# EUROPEAN PATENT SPECIFICATION

(11) **EP 3 319 127 B1**
(45) Date of publication and mention of the grant of the patent: **30.12.2020**
(21) Application number: 16197521.4
(22) Date of filing: 07.11.2016
(51) Int. Cl.: H01L 29/423, H01L 29/78, H01L 29/06, H01L 29/08, H01L 29/10

(54) **FIELD EFFECT TRANSISTOR DEVICE WITH SEPARATE SOURCE AND BODY CONTACTS AND METHOD OF PRODUCING THE DEVICE**
FELDEFFEKTTRANSISTOR MIT GETRENNTEN SOURCE- UND BODY-KONTAKTEN UND VERFAHREN ZUR HERSTELLUNG DER VORRICHTUNG
DISPOSITIF DE TRANSISTOR À EFFET DE CHAMP AVEC DES CONTACTS DE SOURCE ET DE CORPS SÉPARÉS ET PROCÉDÉ DE FABRICATION DU DISPOSITIF

(43) Date of publication of application: 09.05.2018
(73) Proprietor: ams AG, 8141 Premstätten (AT)
(72) Inventor: Knaipp, Martin, 5656 AE Eindhoven (NL); Röhrer, Georg, 5656 AE Eindhoven (NL); Park, Jong Mun, 5656 AE Eindhoven (NL)
(74) Representative: Epping - Hermann - Fischer

(56) References cited:
- EP-A1- 3 098 857
- US-A1- 2005 151 189
- US-A1- 2012 049 277
- US-A1- 2012 187 483
- US-B1- 7 405 128

## Description

A field effect transistor cell comprises the areas of source, drain and body including a channel region. In symmetrical field effect transistors, the cell size is defined by the distance from the axis of symmetry of the body region to the axis of symmetry of the drain region. Small cell sizes are especially important in output stages to achieve a small on-resistance. The cell size is reduced if source and body are provided with a common contact, but this excludes the application of different voltages to source and body, which may be required in some designs of integrated circuits.

US 8 963 243 discloses a p-channel LDMOS transistor with a semiconductor substrate provided with a well of n-type conductivity. A p-type source region, a p⁺-type source contact region and an n-type body contact region are arranged in the well. The contact regions are separated by an isolation region and provided with separate contacts.

US 2015/0123206 A1 discloses a field effect transistor provided with a body-contact. A gate strip is disposed on a first portion of the active region of a substrate. Source and drain regions are disposed on second and third portions of the active region adjacent to opposite sides of the gate strip. A body-contact region is disposed on a fourth portion of the active region separated from the gate strip by a fifth portion of the active region. The fifth portion of the active region is not covered by any silicide features.

EP 3098857 A1 falls under Article 54(3) EPC. It discloses a field-effect transistor with body contacts. A portion of the gate electrode is arranged between one of the source/drain contacts and the body contacts.

US 7,405,128 B1 discloses a MOSFET with a plurality of openings cut through the gate electrode to expose regions of the surface of a P-body region. The exposed regions are contacted by leads. A portion of the gate electrode is arranged between a source contact and the body contacts.

US 2012/0187483 A1 discloses a DMOS device comprising a gate with a ring-shaped structure, a drain located outside the ring, and a lightly doped drain, a source and a body electrode located inside the ring. The gate is provided with sidewall spacers on both sides.

US 2012/0049277 A1 discloses an LD-MOS device with a plurality of source contact plugs and body contact plugs arranged on parallel straight lines.

US 2005/0151189 A1 discloses a method of producing a DMOS structure wherein a body connection plug diffusion P+ is implanted in a P-body region. Source contact regions are produced outside a striplike area by an N+ implant, which overcompensates the P+ implant.

It is an object of the present invention to disclose a field effect transistor device with small cell size that allows to apply different electric potentials to source and body, and a method of producing such a device.

This object is achieved with the field effect transistor device according to claim 1 and with the method of producing a field effect transistor device according to claim 9. Embodiments derive from the dependent claims.

The field effect transistor device according to claim comprises a substrate of semiconductor material, a body well of a first type of electric conductivity in the substrate, a source region in the body well, the source region having an opposite second type of electric conductivity, a source contact on the source region, a body contact region of the first type of electric conductivity in the body well, a body contact on the body contact region, and a gate electrode layer partially overlapping the body well. A portion of the gate electrode layer is present between the source contact and the body contact.

In particular, the first type of electric conductivity may be n-type conductivity. In this case, the second type of electric conductivity is p-type conductivity. The first type of electric conductivity may instead be p-type conductivity and the second type of electric conductivity n-type conductivity.

An embodiment of the device comprises a source spacer and a body spacer at the gate electrode layer. The source spacer is arranged between the gate electrode layer and the source contact, and the body spacer is arranged between the gate electrode layer and the body contact. The body contact may be laterally surrounded by the gate electrode layer.

In a further embodiment, areas of the substrate under the source spacer and under the body spacer are free from silicide.

The source contact is one of a plurality of source contacts, which are arranged on a straight line. The body contact is one of a plurality of body contacts arranged on the straight line, and in particular at equal distances from one another. In particular, the same number of the source contacts may be arranged between any two of the body contacts that immediately follow one another in the sequence of body contacts.

A further embodiment comprises a source extension of the second type of electric conductivity, the source extension extending the source region under the gate electrode layer. The electric conductivity of the source extension is lower than the electric conductivity of the source region. The source extension is embedded in a halo implant of the first type of electric conductivity.

A further embodiment comprises a first metal layer above the substrate. A first portion of the first metal layer contacts the source contact, and a second portion of the first metal layer contacts the body contact.

A further embodiment comprises a second metal layer above the first metal layer. The first portion of the first metal layer is connected to a first portion of the second metal layer by a first via, which forms a vertical electric interconnection, or by a plurality of first vias, and the second portion of the first metal layer is connected to a second portion of the second metal layer by a second via or by a plurality of second vias.

The method of producing a field effect transistor device according to claim 9 comprises forming a body well of a first type of electric conductivity in a substrate of semiconductor material, forming a source region in the body well, the source region having an opposite second type of electric conductivity, applying a source contact on the source region, forming a body contact region of the first type of electric conductivity in the body well, applying a body contact on the body contact region, forming a gate electrode layer partially overlapping the body well, and forming a body spacer at the gate electrode layer.

The body spacer is formed covering an area of the substrate that is free from silicide and surrounding an area provided for the body contact region. The body contact region is formed self-aligned to the gate electrode layer and the body spacer by an implantation of dopant using a mask that has an opening above the region that is provided for the body contact region.

The gate electrode layer is formed in such a manner that a portion of the gate electrode layer is arranged between the source contact and the body contact. If the body contact is arranged between two source contacts, portions of the gate electrode layer may be arranged between the body contact and each of the source contacts.

In a variant of the method, a source spacer is formed at the gate electrode layer. The source spacer covers an area of the substrate that is free from silicide and surrounds an area provided for the source region. The source region is formed self-aligned to the gate electrode layer and the source spacer by an implantation of a further dopant.

In a further variant of the method, a halo implant is formed in an area provided for the source region by an implantation of dopant for the first type of electric conductivity. A source extension is formed in the halo implant by an implantation of dopant for the second type of electric conductivity. The source extension extends the source region under the gate electrode layer towards the channel region. The electric conductivity of the source extension is lower than the electric conductivity of the source region. This is achieved by a lower net doping concentration of the source extension, where the doping for the second type of electric conductivity overcompensates the first type of electric conductivity provided by the body well and the halo implant.

In a further variant of the method, the implantation of dopant for the second type of electric conductivity that is provided for the source extension is also performed in an area provided for the body contact region. The body contact region is formed by an implantation of dopant for the first type of electric conductivity, which overcompensates the implantation for the second type of conductivity and results in a net doping of the first type of electric conductivity throughout the body contact region.

In a further variant of the method, the implantation of the body contact region is deeper than the implantation of the source extension.

The following is a detailed description of examples of the device and the method in conjunction with the appended figures.
Figure 1 is a section of a top view of an embodiment of the device including a first metal layer.
Figure 2 is a cross section of the device at the location indicated in Figure 1 with arrows II.
Figure 3 is a cross section of the device at the location indicated in Figure 1 with arrows III.
Figure 4 is a cross section of the device at the location indicated in Figure 1 with arrows IV.
Figure 5 is a section of a top view according to Figure 1 including a second metal layer.
Figure 6 is a top view of a larger area of the device including the drain contacts.

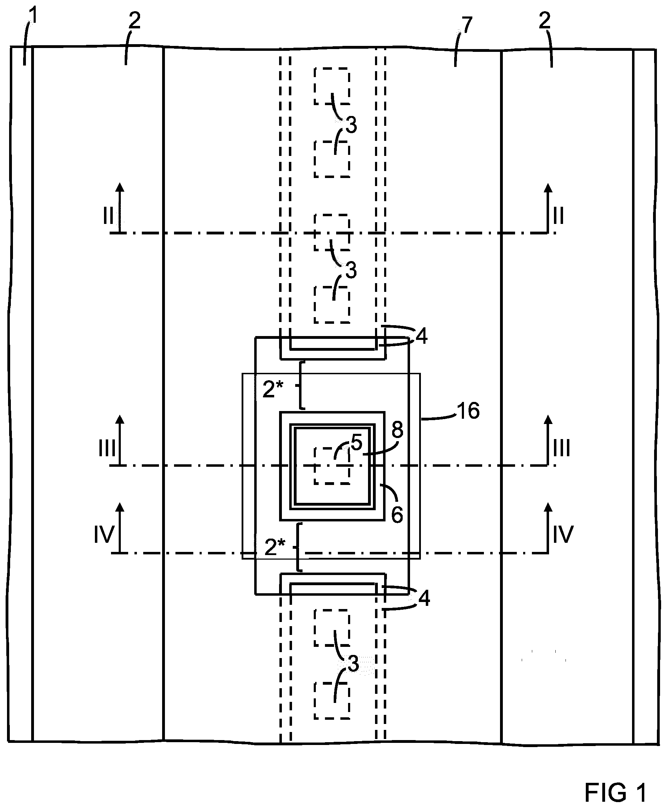

Figure 1 is a section of a top view of an embodiment of the field effect transistor device including only the first metal layer. Hidden contours are represented with broken lines. The field effect transistor device comprises a substrate 1 of semiconductor material, which may especially be silicon, for instance. A structured gate electrode layer 2, which may be electrically conductive polysilicon, for instance, is arranged above the surface of the substrate 1. A body well is formed in the substrate 1. A source region or a plurality of source regions and a body contact region or a plurality of body contact regions are formed in the body well.

Source contact regions 3 are arranged on the source region, and body contact regions 5 are arranged on the body contact region. The source contact 3 and the body contact 5 are arranged on a straight line in the direction that is vertical in Figure 1.

The device comprises a plurality of source contacts 3, and it comprises a plurality of body contacts 5. In the embodiment according to Figure 1, only one of the body contacts 5 is arranged between groups of source contacts 3. A group of body contacts 5 may instead be arranged between source contacts 3.

At least one spacer of dielectric material, which is here referred to as source spacer 4, can be arranged at edges of the gate electrode layer 2 facing the source contact 3. The source spacer 4 may especially surround a group of source contacts 3. There may be a plurality of source spacers 4, and each of the source spacers 4 may surround a separate group of source contacts 3. The source contacts 3 may be arranged at a small distance from the neighbouring source spacer 4.

At least one further spacer of dielectric material, which is here referred to as body spacer 6, can be arranged at further edges of the gate electrode layer 2 facing the body contact 5. The body spacer 6 may surround a single body contact 5, as shown in Figure 1, or a group of body contacts 5. There may be a plurality of body spacers 6, and each of the body spacers 6 may surround a single body contact 5 or a group of body contacts 5. The body contacts 5 may be arranged at a small distance from the neighbouring body spacer 6.

The source contact 3 is connected with a first portion 7 of a first metal layer. If the transistor cell comprises a plurality of source contacts 3, each source contact 3 is connected with the first portion 7 of the first metal layer. The body contact 5 is connected with a second portion 8 of the first metal layer. If the transistor cell comprises a plurality of body contacts 5, each body contact 5 is connected with the second portion 8 of the first metal layer.

In the top view of Figure 1, the source contacts 3 and parts of the source spacers 4 are covered by the first portion 7 of the first metal layer and are therefore shown as hidden contours with broken lines. Similarly, the body contact 5 is covered by the second portion 8 of the first metal layer. The gate electrode layer 2 is partially covered by the first portion 7 of the first metal layer.

Electrically conductive vias may be provided for an electric connection of the gate electrode layer 2 with a further portion of the first metal layer. In particular, the electrically conductive vias may be arranged outside the active area, especially above an insulating region, which may be formed by a field oxide, for instance. Details of an electric connection of the gate electrode layer 2 are not relevant to the invention and are not shown in the figures.

Figure 1 shows how the edges of the gate electrode layer 2 facing the source contacts 3 and the body contact 5 may be lined with the source spacers 4 and the body spacer 6.

Portions 2* of the gate electrode layer 2 are present between the body contact 5 and the adjacent source contacts 3. These portion 2* of the gate electrode layer 2 allow to implant the body contact region at a distance from the source regions and afterwards separate the body contact 5 from the adjacent source contacts 3.

The mask 16, which is used in the implantation of the body contact region, is schematically indicated in Figure 1. The mask 16 may be applied on the gate electrode layer 2 and on regions of the active area that are not covered by the gate electrode layer 2. The mask 16 comprises an opening above the region that is provided for the body contact region.

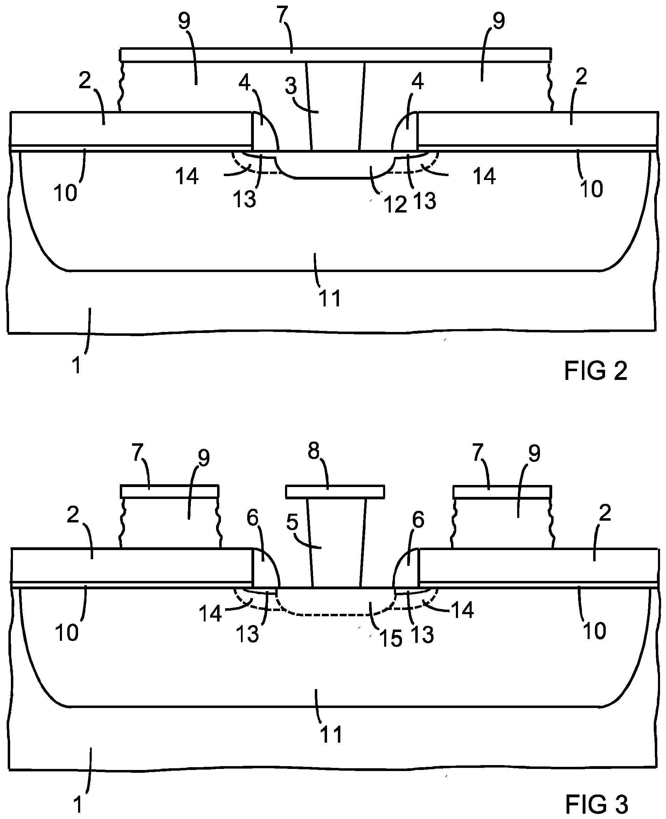

In Figure 1 three locations of cross sections II, III and IV are indicated. These cross sections are respectively shown in Figures 2, 3 and 4, which are described in the following.

Figure 2 is a cross section through a source contact 3. It shows the substrate 1 with the body well 11 and the gate electrode layer 2, which is arranged on a gate dielectric 10. The body well 11 is doped for a first type of electric conductivity, which may be n-type conductivity, for instance. The source spacer 4 is arranged at the lateral edges of the gate electrode layer 2 facing the source contact 3. The area of the substrate 1 that is covered by the source spacer 4 is thus prevented from being silicided. A short circuit, which may be due to an uninterrupted silicide layer, is thereby avoided between the contacts. Figure 2 also shows part of an intermetal dielectric 9, on which the first portion 7 of the first metal layer is applied.

The source region 12 is formed in the body well 11. A source extension 13 of lower doping concentration and hence lower electric conductivity may be provided towards the channel region, which is located under the gate electrode layer 2. The source extension 13 is overlapped by the gate electrode layer 2. The source region 12 and the source extension region 13 are doped for the opposite second type of electric conductivity, which may be p-type conductivity, for instance. The types of conductivity may instead be reversed. A halo implant 14 for the first type of electric conductivity may be provided for the source extension 13. An implantation of a moderately doped region in an oppositely doped halo region may also be used to form an LDD (lightly doped drain) region, which extends the drain region towards the channel region.

Figure 3 is a cross section through a body contact 5. It shows the substrate 1 with the body well 11 and the gate electrode layer 2, which is arranged on the gate dielectric 10. The body spacer 6 is arranged at the lateral edges of the gate electrode layer 2 facing the body contact 5. The area of the substrate 1 that is covered by the body spacer 4 is thus also prevented from being silicided. Figure 3 shows part of the intermetal dielectric 9, on which the first portion 7 and the second portion 8 of the first metal layer are applied.

The body contact region 15 is formed by an implantation of dopant for the first type of electric conductivity. The implantation of the body contact region 15 is deeper than the source extension 13, so that the body contact region 15 continuously extends into the body well 11, as indicated in Figure 3 by the central broken line.

The halo implant 14 has the first type of electric conductivity and can be used for the body contact region 15 as well. It is not necessary to apply a dedicated LDD mask shielding the implantation for the source extension 13 from the body contact region 15. Since no mask openings obeying LDD design rules have to be produced, the area of the body contact region 15 can be made extremely small. The implantation for the body contact region 15 can be deeper than the implantation of the halo implant 14, as shown in Figure 3 by way of example, or vice versa.

The source region 12 and the body contact region 15 are formed self-aligned to the gate electrode layer 2, including the source spacers 4 and the body spacers 6, respectively, as shown in Figures 2 and 3. Therefore the gate electrode layer 2, and in particular portion 2* of the gate electrode layer 2 does not overlap with the source region 12 and the body contact region 15. The vertically shallower portions of the source spacers 4 and the body spacers 6 may not completely shield the implantations, so that the margins of the source region 12 and the body contact region 15 may slightly extend under the source spacers 4 and the body spacers 6.

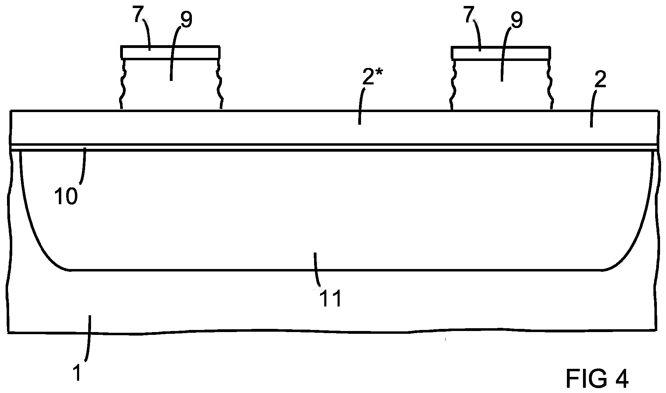

Figure 4 is a cross section through the portion 2* of the gate electrode layer 2 between a source contact 3 and a body contact 5. It shows the substrate 1 with the body well 11 and the gate electrode layer 2, which is arranged on the gate dielectric 10. Figure 4 also shows part of the intermetal dielectric 9, on which the first portion 7 of the first metal layer is applied. The source region 12 and the body contact region 15 are not shown in Figure 4, because the portion 2* of the gate electrode layer 2 does not overlap with the source region 12 and the body contact region 15.

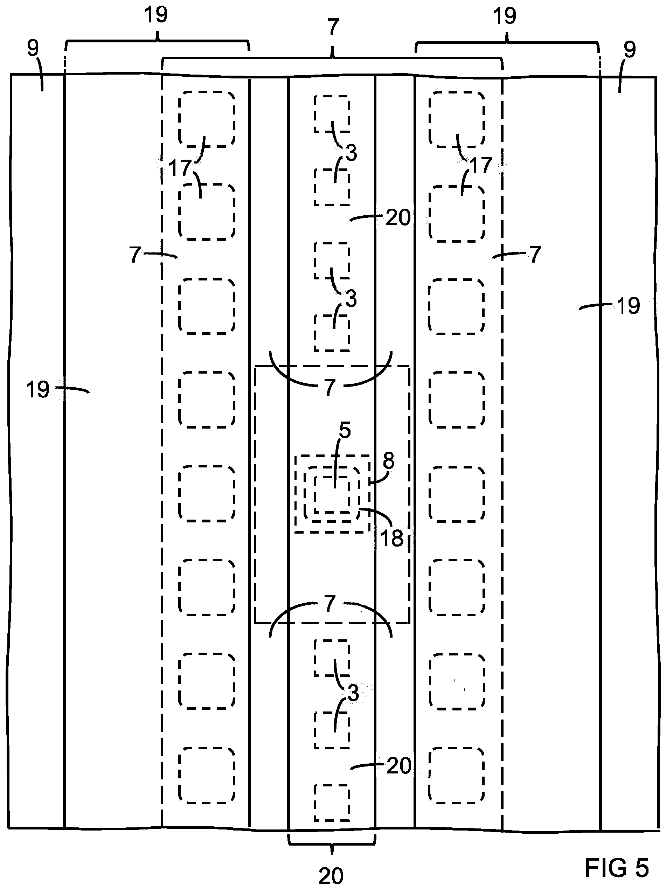

Figure 5 is a section of a top view according to Figure 1 including a second metal layer. The first portion 7 of the first metal layer is connected to a first portion 19 of the second metal layer by a plurality of first vias 17, which are vertical electric interconnections between the first and second metal layers. The second portion 8 of the first metal layer is connected to a second portion 20 of the second metal layer by a second via 18 or by a plurality of second vias 18.

In Figure 5, the first metal layer 7, 8 is assumed to be covered with the intermetal dielectric 9 and is therefore shown with broken lines, whereas the second metal layer 19, 20 is assumed to be uncovered. The positions of the source contacts 3 and the body contact 5 are also indicated.

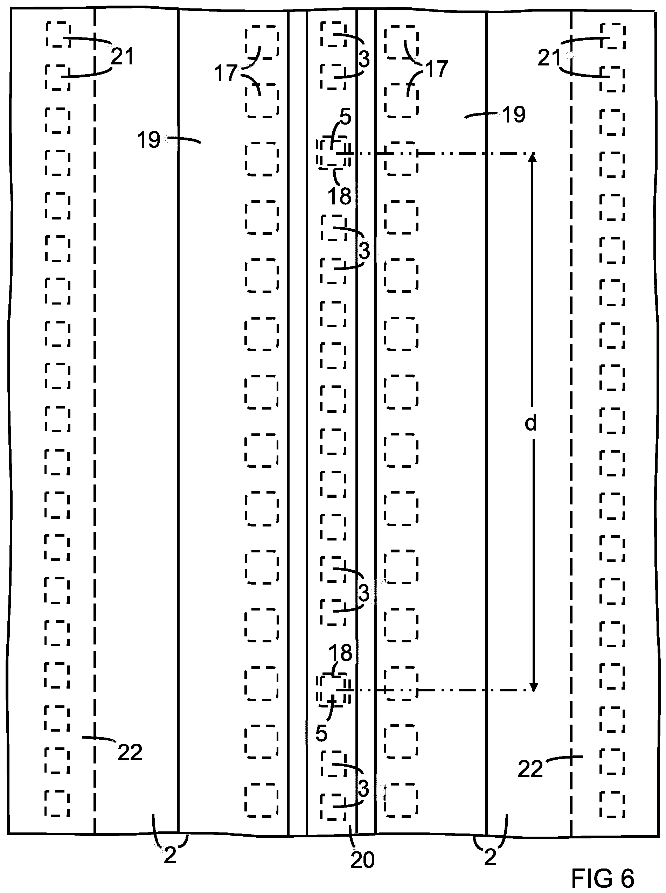

Figure 6 is a top view of a larger area of the device including the drain contacts. Figure 6 shows the gate electrode layer 2, the source contacts 3, the body contacts 5, the first vias 17, the second vias 18, the first portion 19 of the second metal layer and the second portion 20 of the second metal layer. Drain contacts 21 are applied on drain regions 22 in the substrate 1, which are present on two opposite lateral sides of the gate electrode layer 2 in a symmetrical arrangement. The drain contacts 21 are arranged on two straight lines, which are parallel and at equal distances from the straight line running through the centres of the source contacts 3 and the body contacts 5.

In the embodiment according to Figure 6, the arrangement of the regions is symmetrical. The straight line running through the centres of the source contacts 3 and the body contacts 5 is the axis of symmetry. The centres of the body contacts 5 are arranged at a distance d from one another. The arrangement of a group of source contacts 3 and a body contact 5 or group of body contacts 5 may periodically be repeated along the axis of symmetry, so that the body contacts 5 are regularly arranged between the source contacts 3.

The described implantation of the body contact region, which is self-aligned to the gate electrode layer, reduces the size of the transistor cell and thus increases the number of transistor cells that can be disposed in a limited area. The specific on-resistance, which is measured in Ω·mm², is reduced, because the distance of the body contacts from the channel region is smaller than in conventional devices.

### List of reference numerals

- 1: substrate
- 2: gate electrode layer
- 2*: portion of the gate electrode layer
- 3: source contact
- 4: source spacer
- 5: body contact
- 6: body spacer
- 7: first portion of first metal layer
- 8: second portion of first metal layer
- 9: intermetal dielectric
- 10: gate dielectric
- 11: body well
- 12: source region
- 13: source extension
- 14: halo implant
- 15: body contact region
- 16: implantation mask
- 17: first via
- 18: second via
- 19: first portion of second metal layer
- 20: second portion of second metal layer
- 21: drain contact
- 22: drain region
- d: distance

## Claims

1. Field effect transistor device, comprising:
- a substrate (1) of semiconductor material,
- a body well (11) of a first type of electric conductivity in the substrate,
- a source region (12) in the body well (11), the source region (12) having an opposite second type of electric conductivity,
- a source contact (3) on the source region (12),
- a body contact region (15) of the first type of electric conductivity in the body well (11),
- a body contact (5) on the body contact region (15), and
- a gate electrode layer (2) partially overlapping the body well (11),
wherein
- the source contact (3) is one of a plurality of source contacts on a straight line,
- the body contact (5) is one of a plurality of body contacts arranged on the straight line at a distance (d) from one another, and
- a portion (2*) of the gate electrode layer (2) is present on the straight line between the source contact (3) and the body contact (5).

2. Field effect transistor device according to claim 1, further comprising:
- a source spacer (4) at the gate electrode layer (2), the source spacer (4) being arranged between the gate electrode layer (2) and the source contact (3), and
- a body spacer (6) at the gate electrode layer (2), the body spacer (6) being arranged between the gate electrode layer (2) and the body contact (5).

3. Field effect transistor device according to claim 2, wherein areas of the substrate (1) under the source spacer (4) and under the body spacer (6) are free from silicide.

4. Field effect transistor device according to one of claims 1 to 3, further comprising:
the same number of the source contacts (3) being arranged between any two of the body contacts (5) that are spaced apart at the distance (d) from one another.

5. Field effect transistor device according to one of claims 1 to 4, further comprising:
- a source extension (13) of the second type of electric conductivity, the source extension (13) extending the source region (12) under the gate electrode layer (2), the electric conductivity of the source extension (13) being lower than the electric conductivity of the source region (12), and
- a halo implant (14) of the first type of electric conductivity, the source extension (13) being embedded in the halo implant (14).

6. Field effect transistor device according to one of claims 1 to 5, wherein the body contact (5) is laterally surrounded by the gate electrode layer (2).

7. Field effect transistor device according to one of claims 1 to 6, further comprising:
- a first metal layer (7, 8),
- a first portion (7) of the first metal layer contacting the source contact (3), and
- a second portion (8) of the first metal layer contacting the body contact (5).

8. Field effect transistor device according to claim 7, further comprising:
- a second metal layer (19, 20),
- the first portion (7) of the first metal layer being connected to a first portion (19) of the second metal layer by a first via (17), and
- the second portion (8) of the first metal layer being connected to a second portion (20) of the second metal layer by a second via (18).

9. Method of producing a field effect transistor device, comprising:
- forming a body well (11) of a first type of electric conductivity in a substrate (1) of semiconductor material,
- forming a source region (12) in the body well (11), the source region (12) having an opposite second type of electric conductivity,
- applying a source contact (3) on the source region (12),
- forming a body contact region (15) of the first type of electric conductivity in the body well (11),
- applying a body contact (5) on the body contact region (15),
- forming a gate electrode layer (2) partially overlapping the body well (11), and
- forming a body spacer (6) at the gate electrode layer (2), wherein
- the source contact (3) is one of a plurality of source contacts on a straight line,
- the body contact (5) is one of a plurality of body contacts arranged on the straight line at a distance (d) from one another,
- the gate electrode layer (2) is formed with a portion (2*) of the gate electrode layer (2) being present on the straight line between the source contact (3) and the body contact (5),
- the body spacer (6) is formed covering an area of the substrate (1) that is free from silicide and surrounding an area provided for the body contact region (15), and
- the body contact region (15) is formed self-aligned to the gate electrode layer (2) and the body spacer (6) by an implantation of dopant.

10. Method of producing a field effect transistor device according to claim 9, further comprising:
- forming a source spacer (4) at the gate electrode layer (2), the source spacer (4) covering an area of the substrate (1) that is free from silicide and surrounding an area provided for the source region (12), and
- forming the source region (12) self-aligned to the gate electrode layer (2) and the source spacer (4) by an implantation of a further dopant.

11. Method of producing a field effect transistor device according to claim 9 or 10, further comprising:
- forming a halo implant (14) in an area provided for the source region (12) by an implantation of dopant for the first type of electric conductivity, and
- forming a source extension (13) in the halo implant (14) by an implantation of dopant for the second type of electric conductivity, the source extension (13) extending the source region (12) under the gate electrode layer (2), the electric conductivity of the source extension (13) being lower than the electric conductivity of the source region (12).

12. Method of producing a field effect transistor device according to claim 11, further comprising:
- performing the implantation of dopant for the second type of electric conductivity that is provided for the source extension (13) also in an area provided for the body contact region (15), and
- forming the body contact region (15) by an implantation of dopant for the first type of electric conductivity, which overcompensates the implantation for the second type of conductivity and results in a net doping of the first type of electric conductivity throughout the body contact region (15).

13. Method of producing a field effect transistor device according to claim 12, wherein the implantation of the body contact region (15) is deeper than the implantation of the source extension (13).

## Patentansprüche

1. Feldeffekttransistorvorrichtung, umfassend:
- ein Substrat (1) aus Halbleitermaterial,
- eine Body-Wanne (11) eines ersten Typs elektrischer Leitfähigkeit in dem Substrat,
- eine Source-Zone (12) in der Body-Wanne (11) wobei die Source-Zone (12) einen entgegengesetzten, zweiten Typ elektrischer Leitfähigkeit hat,
- einen Source-Kontakt (3) auf der Source-Zone (12),
- eine Body-Kontaktzone (15) des ersten Typs elektrischer Leitfähigkeit in der Body-Wanne (11),
- einen Body-Kontakt (5) auf der Body-Kontaktzone (15), und
- eine Gate-Elektrodenschicht (2), die teilweise die Body-Wanne (11) überlagert,
wobei
- der Source-Kontakt (3) einer von mehreren Source-Kontakten auf einer geraden Linie ist,
- der Body-Kontakt (5) einer von mehreren Body-Kontakten ist, die auf der geraden Linie in einem Abstand (d) voneinander angeordnet sind, und
- ein Teilbereich (2*) der Gate-Elektrodenschicht (2) auf der geraden Linie zwischen dem Source-Kontakt (3) und dem Body-Kontakt (5) vorhanden ist.

2. Feldeffekttransistorvorrichtung nach Anspruch 1, darüber hinaus umfassend:
- einen Source-Abstandshalter (4) an der Gate-Elektrodenschicht (2), wobei der Source-Abstandshalter (4) zwischen der Gate-Elektrodenschicht (2) und dem Source-Kontakt (3) angeordnet ist, und
- einen Body-Abstandshalter (6) an der Gate-Elektrodenschicht (2), wobei der Body-Abstandshalter (6) zwischen der Gate-Elektrodenschicht (2) und dem Body-Kontakt (5) angeordnet ist.

3. Feldeffekttransistorvorrichtung nach Anspruch 2, wobei Bereiche des Substrats (1) unter dem Source-Abstandshalter (4) und unter dem Body-Abstandshalter (6) frei von Silicid sind.

4. Feldeffekttransistorvorrichtung nach einem der Ansprüche 1 bis 3, darüber hinaus umfassend:
dieselbe Anzahl an Source-Kontakten (3), die zwischen beliebigen zwei Body-Kontakten (5) angeordnet sind, die im Abstand (d) voneinander beabstandet sind.

5. Feldeffekttransistorvorrichtung nach einem der Ansprüche 1 bis 4, darüber hinaus umfassend:
- eine Source-Erweiterung (13) des zweiten Typs elektrischer Leitfähigkeit, wobei die Source-Erweiterung (13) die Source-Zone (12) unter der Gate-Elektrodenschicht (2) erweitert, wobei die elektrische Leitfähigkeit der Source-Erweiterung (13) niedriger ist als die elektrische Leitfähigkeit der Source-Zone (12), und
- ein Halo-Implantat (14) des ersten Typs elektrischer Leitfähigkeit, wobei die Source-Erweiterung (13) in das Halo-Implantat (14) eingebettet ist.

6. Feldeffekttransistorvorrichtung nach einem der Ansprüche 1 bis 5, wobei der Body-Kontakt (5) seitlich von der Gate-Elektrodenschicht (2) umgeben ist.

7. Feldeffekttransistorvorrichtung nach einem der Ansprüche 1 bis 6, darüber hinaus umfassend:
- eine erste Metallschicht (7, 8),
- wobei ein erster Teilbereich (7) der ersten Metallschicht den Source-Kontakt (3) kontaktiert, und
- wobei ein zweiter Teilbereich (8) der ersten Metallschicht den Body-Kontakt (5) kontaktiert.

8. Feldeffekttransistorvorrichtung nach Anspruch 7, darüber hinaus umfassend:
- eine zweite Metallschicht (19, 20),
- wobei der erste Teilbereich (7) der ersten Metallschicht über eine erste Durchkontaktierung (17) an einen ersten Teilbereich (19) der zweiten Metallschicht angeschlossen ist, und
- wobei der zweite Teilbereich (8) der ersten Metallschicht über eine zweite Durchkontaktierung (18) an einen zweiten Teilbereich (20) der zweiten Metallschicht angeschlossen ist.

9. Verfahren zur Herstellung einer Feldeffekttransistorvorrichtung, umfassend:
- Ausbilden einer Body-Wanne (11) eines ersten Typs elektrischer Leitfähigkeit in einem Substrat (1) aus Halbleitermaterial,
- Ausbilden einer Source-Zone (12) in der Body-Wanne (11), wobei die Source-Zone (12) einen entgegengesetzten, zweiten Typ elektrischer Leitfähigkeit hat,
- Anbringen eines Source-Kontakts (3) auf der Source-Zone (12),
- Ausbilden einer Body-Kontaktzone (15) des ersten Typs elektrischer Leitfähigkeit in der Body-Wanne (11),
- Anbringen eines Body-Kontakts (5) auf der Body-Kontaktzone (15),
- Ausbilden einer Gate-Elektrodenschicht (2), die teilweise die Body-Wanne (11) überlagert, und
- Ausbilden eines Body-Abstandshalters (6) an der Gate-Elektrodenschicht (2),
wobei
- der Source-Kontakt (3) einer von mehreren Source-Kontakten auf einer geraden Linie ist,
- der Body-Kontakt (5) einer von mehreren Body-Kontakten ist, die auf der geraden Linie in einem Abstand (d) voneinander angeordnet sind,
- die Gate-Elektrodenschicht (2) ausgebildet wird, wobei ein Teilbereich (2*) der Gate-Elektrodenschicht (2) auf der geraden Linie zwischen dem Source-Kontakt (3) und dem Body-Kontakt (5) vorhanden ist,
- der Body-Abstandshalter (6) so ausgebildet wird, dass er einen Bereich des Substrats (1) bedeckt, der frei von Silicid ist, und einen Bereich umgibt, der für die Body-Kontaktzone (15) vorgesehen ist, und
- die Body-Kontaktzone (15) durch eine Implantation eines Dotiermittels selbstausgerichtet zur Gate-Elektrodenschicht (2) und zum Body-Abstandshalter (6) ausgebildet wird.

10. Verfahren zur Herstellung einer Feldeffekttransistorvorrichtung nach Anspruch 9, darüber hinaus umfassend:
- Ausbilden eines Source-Abstandshalters (4) an der Gate-Elektrodenschicht (2), wobei der Source-Abstandshalter (4) einen Bereich des Substrats (1) bedeckt, der frei von Silicid ist, und einen Bereich umgibt, der für die Source-Zone (12) vorgesehen ist, und
- Ausbilden der Source-Zone (12) selbstausgerichtet zur Gate-Elektrodenschicht (2) und zum Source-Abstandshalter (4) durch eine Implantation eines weiteren Dotiermittels.

11. Verfahren zur Herstellung einer Feldeffekttransistorvorrichtung nach Anspruch 9 oder 10, darüber hinaus umfassend:
- Ausbilden eines Halo-Implantats (14) in einem Bereich, der für die Source-Zone (12) vorgesehen ist, durch eine Implantation eines Dotiermittels für den ersten Typ elektrischer Leitfähigkeit, und
- Ausbilden einer Source-Erweiterung (13) in dem Halo-Implantat (14) durch eine Implantation eines Dotiermittels für den zweiten Typ elektrischer Leitfähigkeit, wobei die Source-Erweiterung (13) die Source-Zone (12) unter der Gate-Elektrodenschicht (2) erweitert, wobei die elektrische Leitfähigkeit der Source-Erweiterung (13) niedriger ist als die elektrische Leitfähigkeit der Source-Zone (12).

12. Verfahren zur Herstellung einer Feldeffekttransistorvorrichtung nach Anspruch 11, darüber hinaus umfassend:
- Ausführen der Implantation des Dotiermittels für den zweiten Typ elektrischer Leitfähigkeit, die für die Source-Erweiterung (13) vorgesehen ist, auch in einem Bereich, der für die Body-Kontaktzone (15) vorgesehen ist, und
- Ausbilden der Body-Kontaktzone (15) durch eine Implantation eines Dotiermittels für den ersten Typ elektrischer Leitfähigkeit, welche die Implantation für den zweiten Leitfähigkeitstyp überkompensiert und im Ergebnis zu einer Nettodotierung des ersten Typs elektrischer Leitfähigkeit in der gesamten Body-Kontaktzone (15) führt.

13. Verfahren zur Herstellung einer Feldeffekttransistorvorrichtung nach Anspruch 12, wobei die Implantation der Body-Kontaktzone (15) tiefer ist als die Implantation der Source-Erweiterung (13).

## Revendications

1. Dispositif de transistor à effet de champ, comprenant:
- un substrat (1) de matériau semiconducteur,
- un puits de corps (11) d'un premier type de conductivité électrique dans le substrat,
- une région de source (12) dans le puits de corps (11), la région de source (12) ayant un deuxième type opposé de conductivité électrique,
- un contact de source (3) sur la région de source (12),
- une région de contact de corps (15) du premier type de conductivité électrique dans le puits de corps (11),
- un contact de corps (5) sur la région de contact de corps (15), et
- une couche d'électrode de grille (2) chevauchant partiellement le puits de corps (11),
sachant que
- le contact de source (3) est l'un d'une pluralité de contacts de source sur une ligne droite,
- le contact de corps (5) est l'un d'une pluralité de contacts de corps agencés sur la ligne droite à une distance (d) les uns des autres, et
- une partie (2*) de la couche d'électrode de grille (2) est présente sur la ligne droite entre le contact de source (3) et le contact de corps (5).

2. Dispositif de transistor à effet de champ selon la revendication 1, comprenant en outre:
- une entretoise de source (4) au niveau de la couche d'électrode de grille (2), l'entretoise de source (4) étant agencée entre la couche d'électrode de grille (2) et le contact de source (3), et
- une entretoise de corps (6) au niveau de la couche d'électrode de grille (2), l'entretoise de corps (6) étant agencée entre la couche d'électrode de grille (2) et le contact de corps (5).

3. Dispositif de transistor à effet de champ selon la revendication 2, sachant que des zones du substrat (1) sous l'entretoise de source (4) et sous l'entretoise de corps (6) sont exemptes de siliciure.

4. Dispositif de transistor à effet de champ selon l'une des revendications 1 à 3, comprenant en outre:
le même nombre des contacts de source (3) qui sont agencés entre deux quelconques des contacts de corps (5) qui sont espacés à raison de la distance (d) l'un de l'autre.

5. Dispositif de transistor à effet de champ selon l'une des revendications 1 à 4, comprenant en outre:
- une extension de source (13) du deuxième type de conductivité électrique, l'extension de source (13) étendant la région de source (12) sous la couche d'électrode de grille (2), la conductivité électrique de l'extension de source (13) étant inférieure à la conductivité électrique de la région de source (12), et
- un implant halo (14) du premier type de conductivité électrique, l'extension de source (13) étant logée dans l'implant halo (14).

6. Dispositif de transistor à effet de champ selon l'une des revendications 1 à 5, sachant que le contact de corps (5) est entouré latéralement par la couche d'électrode de grille (2).

7. Dispositif de transistor à effet de champ selon l'une des revendications 1 à 6, comprenant en outre:
- une première couche de métal (7, 8),
- une première partie (7) de la première couche de métal étant en contact avec le contact de source (3), et
- une deuxième partie (8) de la première couche de métal étant en contact avec le contact de corps (5).

8. Dispositif de transistor à effet de champ selon la revendication 7, comprenant en outre:
- une deuxième couche de métal (19, 20),
- la première partie (7) de la première couche de métal étant connectée à une première partie (19) de la deuxième couche de métal par une première interconnexion (17), et
- la deuxième partie (8) de la première couche de métal étant connectée à une deuxième partie (20) de la deuxième couche de métal par une deuxième interconnexion (18).

9. Procédé de production d'un dispositif de transistor à effet de champ, comprenant:
- la formation d'un puits de corps (11) d'un premier type de conductivité électrique dans un substrat (1) de matériau semiconducteur,
- la formation d'une région de source (12) dans le puits de corps (11), la région de source (12) ayant un deuxième type opposé de conductivité électrique,
- l'application d'un contact de source (3) sur la région de source (12),
- la formation d'une région de contact de corps (15) du premier type de conductivité électrique dans le puits de corps (11),
- l'application d'un contact de corps (5) sur la région de contact de corps (15),
- la formation d'une couche d'électrode de grille (2) chevauchant partiellement le puits de corps (11), et
- la formation d'une entretoise de corps (6) au niveau de la couche d'électrode de grille (2), sachant que
- le contact de source (3) est l'un d'une pluralité de contacts de source sur une ligne droite,
- le contact de corps (5) est l'un d'une pluralité de contacts de corps agencés sur la ligne droite à une distance (d) les uns des autres,
- la couche d'électrode de grille (2) est formée avec une partie (2*) de la couche d'électrode de grille (2) étant présente sur la ligne droite entre le contact de source (3) et le contact de corps (5),
- l'entretoise de corps (6) est formée de manière à recouvrir une zone du substrat (1) qui est exempte de siliciure et entourer une zone prévue pour la région de contact de corps (15), et
- la région de contact de corps (15) est formée en autoalignement par rapport à la couche d'électrode de grille (2) et l'entretoise de corps (6) par une implantation de dopant.

10. Procédé de production d'un dispositif de transistor à effet de champ selon la revendication 9, comprenant en outre:
- la formation d'une entretoise de source (4) au niveau de la couche d'électrode de grille (2), l'entretoise de source (4) recouvrant une zone du substrat (1) qui est exempte de siliciure et entourant une zone prévue pour la région de source (12), et
- la formation de la région de source (12) en autoalignement par rapport à la couche d'électrode de grille (2) et l'entretoise de source (4) par une implantation d'un dopant supplémentaire.

11. Procédé de production d'un dispositif de transistor à effet de champ selon la revendication 9 ou 10, comprenant en outre:
- la formation d'un implant halo (14) dans une zone prévue pour la région de source (12) par une implantation de dopant pour le premier type de conductivité électrique, et
- la formation d'une extension de source (13) dans l'implant halo (14) par une implantation de dopant pour le deuxième type de conductivité électrique, l'extension de source (13) étendant la région de source (12) sous la couche d'électrode de grille (2), la conductivité électrique de l'extension de source (13) étant inférieure à la conductivité électrique de la région de source (12).

12. Procédé de production d'un dispositif de transistor à effet de champ selon la revendication 11, comprenant en outre:
- l'exécution de l'implantation de dopant pour le deuxième type de conductivité électrique qui est prévu pour l'extension de source (13) aussi dans une zone prévue pour la région de contact de corps (15), et
- la formation de la région de contact de corps (15) par une implantation de dopant pour le premier type de conductivité électrique, qui surcompense l'implantation pour le deuxième type de conductivité et aboutit à un dopage net du premier type de conductivité électrique sur toute la région de contact de corps (15).

13. Procédé de production d'un dispositif de transistor à effet de champ selon la revendication 12, sachant que l'implantation de la région de contact de corps (15) est plus profonde que l'implantation de l'extension de source (13).
